# EUROPÄISCHE PATENTSCHRIFT

(11) **EP 1 366 554 B1**
(45) Veröffentlichungstag und Bekanntmachung des Hinweises auf die Patenterteilung: **20.07.2005**
(21) Anmeldenummer: 03727141.8
(22) Anmeldetag: 14.03.2003
(51) Int. Cl.: H02J 17/00, G01R 15/14

(54) **ANORDNUNG ZUR ELEKTRISCHEN ENERGIEVERSORGUNG EINES VERBRAUCHERS MITTELS EINER ZWEIGETEILTEN ÜBERTRAGUNGSSTRECKE**
ARRANGEMENT FOR THE ELECTRIC POWER SUPPLY OF A CONSUMER BY MEANS OF A TRANSMISSION PATH DIVIDED INTO TWO
DISPOSITIF D'ALIMENTATION ELECTRIQUE D'UN RECEPTEUR AU MOYEN D'UN PARCOURS DE TRANSMISSION EN DEUX PARTIES

(30) Priorität: 27.03.2002 DE 10213845
(43) Veröffentlichungstag der Anmeldung: 03.12.2003
(73) Patentinhaber: Siemens Aktiengesellschaft, 80333 München (DE)
(72) Erfinder: BIRKLE, Siegfried, 91315 Höchstadt (DE); HAIN, Stefan, 91090 Effeltrich (DE)
(86) Internationale Anmeldenummer: PCT/DE2003/000837
(87) Internationale Veröffentlichungsnummer: WO 2003/081746

(56) Entgegenhaltungen:
- DE-A- 2 428 906
- DE-C- 910 925

## Beschreibung

Die Erfindung betrifft eine Anordnung zum potentialgetrennten Versorgen eines elektrischen Verbrauchers mit elektrischer Energie.

Im allgemeinen wird ein elektrischer Verbraucher von einer Spannungs- oder Stromquelle über eine einfache elektrische Leitung mit elektrischer Energie in Form einer Versorgungsspannung oder eines Versorgungsstroms versorgt.

Manchmal benötigt man eine potentialgetrennte (= galvanisch getrennte) Energieversorgung des Verbrauchers ohne eine ohmsche Verbindung zwischen dem Verbraucher und der Versorgungsquelle. Ist der elektrische Verbraucher auf einem elektrischen Potential angeordnet, das sich sehr stark von dem der Energiequelle unterscheidet, oder sind sehr hohe Anforderungen an die elektromagnetische Verträglichkeit (EMV) zu erfüllen, so ist die Versorgung über eine einfache elektrische Zuleitung zumindest schwierig. Beispiele für solche Anwendungen sind die Strom- und Spannungsmessung in Einrichtungen der öffentlichen Energieversorgung und die EKG-, Atem- oder Pulsmessung an einem Patienten während einer parallel durchgeführten Kernspintomographie-Untersuchung.

Bekannt ist eine Anordnung, bei der Licht einer Lichtquelle, beispielsweise einer Laserdiode oder einer Leuchtdiode (LED), zu einem photoelektrischen Wandler übertragen wird und dort in elektrische Energie umgewandelt wird. Letztere dient der Versorgung des Verbrauchers. Zur Lichtübertragung sind die Lichtquelle und der photoelektrische Wandler über einen Lichtwellenleiter oder auch über eine Freistrahlanordnung optisch miteinander verbunden. Ein solches potentialgetrenntes, optisch betriebenes Versorgungssystem für einen elektrischen Sensor ist beispielsweise in *"Sensors and Actuators A", Band 25 bis 27 (1991), Seiten 475 bis 480,* beschrieben. Das Licht einer Laserdiode wird über einen Lichtwellenleiter zu einem Photoelementarray übertragen und von diesem in die elektrische Energie für den Sensor umgewandelt. Die Messdaten des Sensors werden ebenfalls optisch über einen Lichtwellenleiter übertragen. Aufgrund der verwendeten Spezialkomponenten insbesondere des leistungsstarken Lasers, des Photoelementarrays und auch der optischen Steckverbindungen ist dieses Versorgungssystem jedoch mit einem nicht unerheblichen Aufwand verbunden.

Weiterhin ist eine Anordnung bekannt, bei der die elektrische Energie aus dem unmittelbaren Umfeld eines zu versorgenden elektrischen Sensors gewonnen wird, beispielsweise induktiv aus einem Hochspannungsnetz oder photovoltaisch aus der Sonneneinstrahlung. Bei dieser Anordnung zur Energieversorgung tritt jedoch der unerwünschte Nebeneffekt auf, dass keine elektrische Energie zur Verfügung steht, wenn das Hochspannungsnetz außer Betrieb ist oder die Sonne nicht scheint. Eine Anordnung, die ihre elektrische Energie aus dem Hochspannungsnetz bezieht, ist in der *DE 25 46 694 A1* beschrieben.

Eine andere Anordnung zur potentialgetrennten Versorgung eines elektrischen Verbrauchers mit elektrischer Energie wird mit der *DE 44 42 677 A1* offenbart. Hierbei sendet ein Funksender Energie in Form von Funkwellen zu einem Funkempfänger, der die Funkwellen in die elektrische Energie für den elektrischen Verbraucher umwandelt. Handelt es sich bei dem Verbraucher um einen Sensor, so werden auch die Messdaten des Sensors über Funk übertragen. Mit dieser Anordnung ist somit eine galvanisch getrennte, leitungslose Energie- und Datenübertragung möglich. Gesetzliche Bestimmungen über den Funkverkehr schränken allerdings die Einsatzmöglichkeit dieser Anordnung ein.

Ein weiterer bekannter Ansatz zur potentialgetrennten Energieversorgung eines Verbrauchers, der sich insbesondere auf einem Hochspannungspotential befindet, besteht in der Einspeisung von hochfrequenter elektrischer Energie in einen hochspannungsfesten Kondensator oder in einen gegebenenfalls zur Spannungsmessung ohnehin vorhandenen kapazitiven Teiler. Der Kondensator oder der kapazitive Teiler überbrückt dabei den Potentialunterschied. Ungünstigerweise können sich undefinierte Impedanzverhältnisse einstellen. Während der Kondensator oder der kapazitive Teiler als Hinleitung für die hochfrequente Energie dienen, erfolgt die Rückleitung nämlich weitgehend undefiniert über eine Leiter-Erd-Kapazität einer vorhandenen Hochspannungsfreileitung oder/und über ein benachbartes Betriebsmittel. Um die Funktionsfähigkeit dennoch sicherzustellen, ist eine relativ hohe Speisefrequenz, beispielsweise von > 10 MHz, erforderlich. Dann wirkt die Anordnung insgesamt aber als Sendeantenne, was einerseits zu einem unerwünschten Energieverlust durch Abstrahlung und andererseits zu Kollisionen mit den bereits genannten gesetzlichen Bestimmungen über den Funkverkehr führt.

Auch bei der mit der *DE 910 925* offenbarten Anordnung zur Regelung der Ansteuerung von Gas- oder Dampfentladungsstrecken wird ein hochfrequentes Signal mittels kapazitiver Komponenten übertragen. Es ist ein erster kapazitiver Teilzweig für die Vorwärtsrichtung und ein zweiter kapazitiver Teilzweig für die Rückwärtsrichtung vorgesehen. Das hochfrequente Signal dient allerdings nicht der Energieversorgung, sondern vielmehr der Steuerung einer auf Hochspannungspotential angeordneten Zündschaltung.

In der *DE 29 11 476 A1* wird eine Weiterentwicklung der mit der DE 910 925 offenbarten Übertragungsstrecke zu einer Anordnung zur Energieversorgung eines auf Hochspannungspotential befindlichen Verbrauchers beschrieben. Die Übertragungsstrecke ist hierbei als eine mit Längskondensatoren und Querdrosseln aufgebaute symmetrische Siebkette ausgebildet. Die Querdrosseln sind ausdrücklich deswegen in die Anordnung mitaufgenommen worden, um den Hochfrequenzgenerator von der Blindleistungsbereitstellung zu entlasten und um zwischen benachbarten Kondensatoren auftretende Isolationsdifferenzen auszugleichen. Durch die Vielzahl der benötigten Einzelkomponenten ist die Anordnung jedoch aufwendig in der Realisierung.

Der Erfindung liegt nun die Aufgabe zugrunde, eine Anordnung zum Versorgen eines elektrischen Verbrauchers mit elektrischer Energie anzugeben, die eine möglichst einfache Energieversorgung gewährleistet und gleichzeitig zu keinen Kollisionen mit den gesetzlichen Bestimmungen über den Funkverkehr führt.

Zur Lösung der Aufgabe wird eine Anordnung zum potentialgetrennten Versorgen eines elektrischen Verbrauchers mit elektrischer Energie entsprechend den Merkmalen des Patentanspruchs 1 oder 8 angegeben.

Die Erfindung beruht dabei auf der Erkenntnis, dass anhand einer mittels zweier getrennter Teilzweige realisierten Übertragungsstrecke definierte Impedanzverhältnisse in Vorwärts- und auch in Rückwärtsrichtung des Speisesignals erreicht werden können. Der Speisestromkreis ist dann nicht mehr über eine undefinierte Luftstrecke geschlossen, sondern über den als Rückleitung für das Speisesignal bestimmten Teilzweig. Die beiden Teilzweige sind insbesondere vollständig voneinander getrennt aufgebaut, d.h. außer am Ort des Generators und des Verbrauchers besteht zwischen beiden Teilzweigen keine elektrisch leitende Verbindung.

Aufgrund der definierten Impedanzverhältnisse und auch der niedrigen Verbraucherleistung kann das Speisesignal insbesondere eine relativ niedrige Speisefrequenz, beispielsweise von ≤ 1 MHz, aufweisen. Die Übertragung des Speisesignals erfolgt in beiden Teilzweigen leitungsgebunden und insbesondere elektrisch. Dadurch wird eine Funk-Abstrahlung des Speisesignals weitgehend unterbunden, so dass die gesetzlichen Bestimmungen über den Funkverkehr nicht tangiert werden.

Aufgrund der geringen Übertragungsverluste - insbesondere kommt es auf der Übertragungsstrecke zu keiner unerwünschten Abstrahlung von Speiseenergie - sowie aufgrund der niedrigen Verbraucherleistung kann ein relativ leistungsarm ausgelegter und damit preiswerter Speisesignal-Generator eingesetzt werden.

Es wurde nämlich außerdem erkannt, dass die bei der aus der DE 29 11 476 A1 bekannten Anordnung eingesetzten Querdrosseln ohne wesentliche Funktionseinbuße weggelassen werden können. Dies gilt gerade dann, wenn dem Verbraucher über das Speisesignal nur eine geringe Leistung, beispielsweise von höchstens 100 mW zugeführt wird. Der Speisesignal-Generator kann die für die Teilzweige gegebenenfalls erforderliche Ladeleistung in diesem Leistungsbereich selbst aufbringen. Besondere Vorkehrungen sind hierfür ebenso wenig notwendig wie eine besondere Dimensionierung des Generators. Insgesamt ergibt sich also durch den Wegfall der Querdrosseln und die leistungsarme Auslegung des Generators eine sehr einfache und preisgünstige Anordnung zur potentialgetrennten Energieversorgung eines Verbrauchers.

Vorteilhafte Ausgestaltungen der Anordnung gemäß der Erfindung ergeben sich aus den von Anspruch 1 abhängigen Ansprüchen.

Die Anordnung lässt sich mit besonderem Vorteil einsetzen, wenn zwischen dem Ort des Verbrauchers und dem des Generators eine Potentialdifferenz vorhanden ist. Dann wirkt sich die potentialgetrennte Energieversorgung besonders günstig aus. Insbesondere kann sich der Generator auf Erdpotential und der Verbraucher auf einem hohen Potential, beispielsweise auf einem Potential von einigen 10 kV, befinden.

Weiterhin sind die beiden Teilzweige vorzugsweise eng benachbart zueinander angeordnet. Dadurch sinkt der Platzbedarf der Anordnung. Außerdem verhindert die enge räumliche Nachbarschaft beider Teilzweige, dass eine an sich unerwünschte Abstrahlung von Speiseenergie erfolgt. Die beiden jeweils für die Vorwärts- oder Rückwärtsrichtung bestimmten Teilzweige wirken ähnlich wie eine bifilare Leiteranordnung, bei der sich eine wechselseitige Kompensation des Abstrahlverhaltens einstellt. Insbesondere sind die beiden Teilzweige nebeneinander in einem Isolator untergebracht, wodurch die Kosten für die Spannungs-Isolierung der beiden Teilzweige reduziert werden. Es kann zumindest ein gemeinsames Isolatorgehäuse verwendet werden.

Vorzugsweise lässt sich die Übertragungsstrecke der Anordnung außer zur Energieversorgung auch noch für einen anderen Zweck, beispielsweise zur Spannungsmessung einsetzen. Dann kann die Anordnung zur Energieversorgung in einem anderen ohnehin vorhandenen Betriebsmittel integriert werden, wodurch die Kosten für die Anordnung weiter begrenzt werden können. Insbesondere kann die Übertragungsstrecke auch zur Erfassung der elektrischen Spannung zwischen dem Ort des Verbrauchers und Masse dienen.

Bei einer anderen Ausgestaltung enthalten die Teilzweige als Mittel zur Potentialtrennung jeweils mindestens eine Reaktanz. Besonders vorteilhaft ist hierbei eine Kapazität, die sich gut für die gewünschte Potentialtrennung verwenden lässt. Insbesondere kann auch jeder der Teilzweige eine standardisierte oder serienmäßige Komponente, beispielsweise in Form eines gewickelten Kondensatorstrangs, beinhalten. Dadurch ergibt sich eine besonders preiswerte Realisierung. Als Reaktanz kann aber auch eine Induktivität zum Einsatz kommen.

Günstig ist es, wenn das Speisesignal eine Speisefrequenz hat die zwischen etwa 1 kHz und etwa 1 MHz liegt. In diesem Frequenzbereich kann eine Abstrahlung von Speiseenergie gut unterbunden werden. Außerdem ist die genannte Untergrenze weit genug von einer in Einrichtungen der öffentlichen Energieversorgung eingesetzten Netzfrequenz (DC oder 50 Hz oder 60 Hz) sowie von deren für Mess- und Auswertungszwecke gegebenenfalls relevanten Oberwellen entfernt, so dass eine Beeinflussung ausgeschlossen werden kann.

Es gibt auch eine Anordnung, die mit einem als Gleichsignal ausgebildeten Speisesignal betrieben wird. Hier ist eine Abstrahlung von vornherein ausgeschlossen. Eine Potentialdifferenz wird bei dieser Anordnung vorzugsweise mittels in den Teilzweigen vorgesehener Induktivitäten überbrückt.

Der mit elektrischer Energie versorgte Verbraucher kann beispielsweise ein Messgerät, insbesondere ein Strommessgerät sein. Die Übertragungsstrecke kann dann außer zur Übertragung des Speisesignals auch zur insbesondere elektrischen Übertragung eines vom Messgerät ermittelten Messsignals verwendet werden. Vorzugsweise unterscheidet sich eine hierfür vorgesehene Messsignalfrequenz von der Speisefrequenz, um eine Beeinflussung zu vermeiden. Grundsätzlich kommt aber auch für die Messsignalfrequenz der gleiche Frequenzbereich wie für die Speisefrequenz in Betracht. Durch die Integration von verschiedenen Funktionen in die Übertragungsstrecke kann eine Kosteneinsparung erzielt werden.

Grundsätzlich ist es auch möglich, die von einem als Messgerät ausgebildeten Verbraucher ermittelte Messinformation über eine zusätzliche Übertragungsstrecke zu übertragen. Die zur Speise- und zur Messsignalübertragung eingesetzten Übertragungsstrecken sind dann getrennt voneinander aufgebaut. Sie können sich auch unterschiedlicher Übertragungsprinzipien bedienen, beispielsweise der elektrischen bzw. optischen Übertragung. Dadurch wird eine besonders gute Trennung zwischen Speise- und Messsignal erreicht.

Bevorzugte, jedoch keinesfalls einschränkende Ausführungsbeispiele der Erfindung werden nunmehr anhand der Zeichnung näher erläutert. Zur Verdeutlichung ist die Zeichnung nicht maßstäblich ausgeführt, und gewisse Merkmale sind schematisiert dargestellt. Im einzelnen zeigen die:
- Figur 1: eine in einen kapazitiven Spannungswandler integrierte Anordnung zur potentialgetrennten Energieversorgung,
- Figur 2: eine Anordnung zur potentialgetrennten Energieversorgung eines Messgeräts mit optischer Messsignalübertragung,
- Figur 3: eine Anordnung zur potentialgetrennten Energieversorgung eines Messgeräts mit elektrischer Messsignalübertragung und
- Figur 4: eine weitere Anordnung zur potentialgetrennten Energieversorgung eines Messgeräts mit optischer Messsignalübertragung.

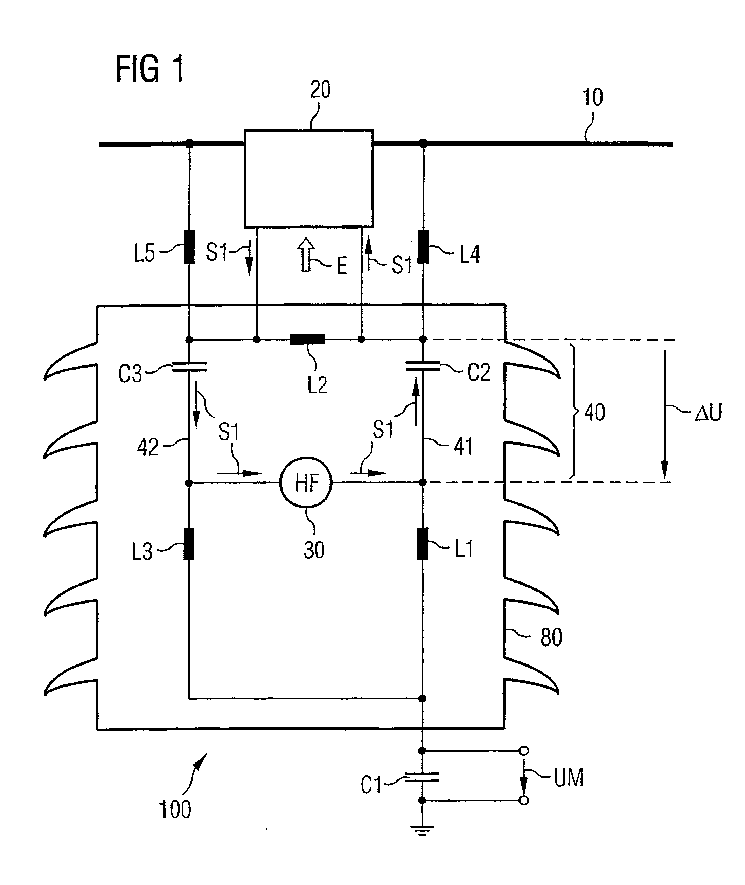

Einander entsprechende Teile sind in den Figuren 1 bis 4 mit denselben Bezugszeichen versehen.

In Figur 1 ist eine Anordnung 100 zur potentialgetrennten Energieversorgung eines Verbrauchers 20 dargestellt. Der Verbraucher 20 ist benachbart zu einem Hochspannungsleiter 10 angeordnet und befindet sich somit also auf Hochspannungspotential, d.h. auf einem Potential von mindestens einigen 10 kV.

Dem Verbraucher 20 wird über ein Speisesignal S1, das mittels einer Übertragungsstrecke 40 übertragen wird, Energie E zugeführt. Um eine Potentialtrennung zu gewährleisten, enthält die Übertragungsstrecke 40 im Beispiel von Figur 1 zwei Übertragungs-Kapazitäten C2 und C3, an denen jeweils eine Potentialdifferenz ΔU abfällt, die den wesentlichen Teil der Leiter-Erd-Spannung des Hochspannungsleiters 10 bildet.

Das Speisesignal S1 wird von einem praktisch auf Massepotential liegenden Generator 30 beispielsweise mit einer Frequenz von 100 kHz erzeugt. Es wird in einen die Übertragungs-Kapazitäten C2 umfassenden ersten Teilzweig 41 der Übertragungsstrecke 40 eingespeist und zum Verbraucher 20 übertragen. Im Verbraucher 20 wird dem Speisesignal S1 in nicht näher dargestellter, aber an sich bekannter Weise die Energie E entnommen und dem Verbraucher 20 zum Betrieb der insbesondere vorhandenen elektronischen Komponenten zur Verfügung gestellt. Hierbei kann die dem Speisesignal S1 entnommene Energie E durchaus zunächst in einem elektrischen Speicher, zum Beispiel in Form eines Kondensators, zwischengespeichert werden.

Im Unterschied zu einer ersten bekannten Anordnung, bei der die Rückwärtsrichtung zwischen dem Verbraucher 20 und dem Generator 30 über eine in ihrem Impedanzwert relativ undefinierte Luftstrecke gebildet ist, weist die Übertragungsstrecke 40 der Anordnung 100 einen zweiten Teilzweig 42 auf. Letzterer beinhaltet die zweite Übertragungs-Kapazität C3, die vorzugsweise den gleichen Kapazitätswert hat wie die erste Übertragungs-Kapazität C2. Nach Passieren des Verbrauchers 20 wird das Speisesignal S1 in dem zweiten Teilzweig 42 zum Generator zurückgeführt. Die zweite Übertragungs-Kapazität C3 sorgt damit auch bei der Übertragung in Rückwärtsrichtung für einen wohl definierten Impedanzwert. Es liegt also ein geschlossener Stromkreis mit definierten Impedanzverhältnissen vor. Dadurch ist es möglich, mit einer vergleichsweise niedrigen Speisefrequenz im Bereich zwischen 1 kHz und 1 MHz und auch mit einer niedrigen Speiseleistung zu arbeiten. Der bei der Realisierung der Anordnung 100 erforderliche Aufwand sinkt folglich.

Im Unterschied zu einer weiteren bekannten Anordnung, die eine Übertragungsstrecke in Form einer Siebkette beinhaltet, sind bei der Anordnung 100 die beiden Teilzweige 41 und 42 der Übertragungsstrecke 40 vollständig voneinander getrennt aufgebaut. Dies bedeutet, dass außer am Generator 30 und am Verbraucher 20 zwischen den beiden Teilzweigen 41 und 42 keine elektrisch leitende Verbindung existiert. Sie sind in diesem Bereich elektrisch gegeneinander isoliert. Insbesondere sind im Unterschied zur bekannten Siebkette keine Querdrosseln als verbindende Elemente vorgesehen. Es wurde erkannt, dass dieser deutlich einfachere Aufbau vorzugsweise dann möglich ist, wenn das Speisesignal S1 eine relativ niedrige Speiseleistung hat. Der Generator 30 kann die Ladeleistung für die Übertragungs-Kapazitäten C2 und C3 in diesem Fall selbst zur Verfügung stellen. Insgesamt lässt sich der Verbraucher 20 mittels der Anordnung 100 in besonders einfacher und kostengünstiger Weise mit einer Leistung von bis zu 100 mW versorgen. Dies reicht zum Betrieb vieler der derzeit gängigen elektronischen Schaltungen aus.

Um ein unerwünschtes Abfließen von Speiseenergie zu vermeiden, sind mehrere Sperr-Induktivitäten L1 bis L5 vorgesehen. Sie sind jeweils so dimensioniert, dass sie bei der Speisefrequenz sehr hochohmig sind und im Idealfall einen Leerlauf darstellen. Die Sperr-Induktivitäten L1 und L3 verhindern ein Abfließen des Speisesignals S1 über Masse, die Sperr-Induktivitäten L4 und L5 dagegen ein Abfließen über den Hochspannungsleiter 10. Die Sperr-Induktivität L2 zwingt das Speisesignal S1 in den Verbraucher 20. Zur Verdeutlichung ist der Signalweg des Speisesignals S1 in Figur 1 durch Pfeile mit durchgezogener Linie angezeigt.

Bei Bedarf können die Sperr-Induktivitäten L1 bis L5 auch um Überspannungsableiter und/oder Dämpfungswiderstände ergänzt werden.

Bei der Netzfrequenz (= DC oder 50 Hz oder 60 Hz) des Hochspannungsleiters 10 stellen die Sperr-Induktivitäten L1 bis L5 keinen Leerlauf, sondern praktisch einen Kurzschluss dar. Zumindest nehmen sie bei dieser Frequenz einen sehr niedrigen Impedanzwert an. Die beiden Teilzweige 41 und 42 sind bei der Netzfrequenz also parallel und nicht wie bei der Speisefrequenz in Serie geschaltet. Somit können die bei der Netzfrequenz parallel geschalteten Übertragungs-Kapazitäten C2 und C3 auch als Hochspannungs-Kapazität eines kapazitiven Spannungswandlers eingesetzt werden. An einer zusätzlich vorgesehenen Niederspannungs-Kapazität C1 kann dann ein Spannungsmesssignal UM für die Leiter-Erd-Spannung des Hochspannungsleiters 10 abgegriffen werden. Die Anordnung 100 erfüllt eine Doppelfunktion. Sie dient der Energieversorgung des Verbrauchers 20 und der Spannungsmessung. Eine besonders einfache und damit vorteilhafte Realisierung der Anordnung 100 erhält man durch eine Integration in einen kommerziell erhältlichen kapazitiven Spannungswandler. Günstig im Hinblick auf die Kosten ist es außerdem, wenn die Übertragungs-Kapazitäten C2 und C3 als standardisierte oder serienmäßige Komponenten, beispielsweise in Form eines gewickelten Kondensatorstrangs, ausgeführt sind.

Je nach Bauform der Übertragungs-Kapazitäten C2 und C3 können sie auch eine Serieninduktivität aufweisen. Dies ist beispielsweise bei dem genannten gewickelten Kondensatorstrang der Fall. Günstig ist es dann, die grundsätzlich im Bereich zwischen 1 kHz und 1 MHz frei wählbare Speisefrequenz gerade auf die Serienresonanzfrequenz, die durch die Serieninduktivität und den Kapazitätswert der Übertragungs-Kapazitäten C2 oder C3 gebildet ist, zu legen. Die beiden Teilzweige 41 und 42 stellen dann für das Speisesignal S1 eine besonders niederohmige Impedanz dar.

Die Spannungsdifferenz zwischen den beiden Teilzweigen 41 und 42 ist nur sehr niedrig (z.B. einige 10 V), so dass eine Isolierung gegeneinander problemlos möglich ist. Sie können somit insbesondere sehr eng benachbart zueinander platziert und beispielsweise auch in einem gemeinsamen Isolator 80 untergebracht werden. Dies ist eine sehr kostensparende Lösung. Durch die enge räumliche Anordnung der Teilzweige 41 und 42 erreicht man außerdem, dass eine ohnehin aufgrund der niedrigen Speisefrequenz bereits stark reduzierte Abstrahlung von Speiseenergie praktisch vollständig unterdrückt wird.

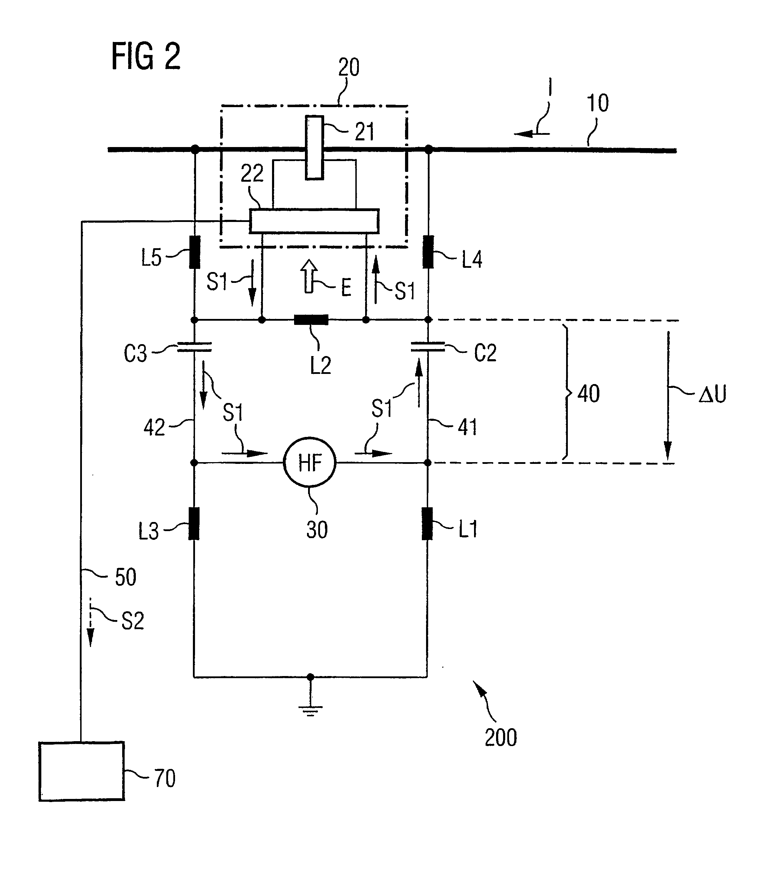

In Figur 2 ist eine andere Anordnung 200 gezeigt, die ebenfalls zur potentialgetrennten Energieversorgung eines Verbrauchers 20 bestimmt ist. Im Beispiel von Figur 2 ist der Verbraucher 20 als Messgerät zur Erfassung eines im Hochspannungsleiter 10 fließenden Stroms I ausgebildet. Das Messgerät 20 enthält einen Mess-Shunt 21 und eine Messkopfelektronik 22, in der ein Messsignal S2 für den Strom I ermittelt wird. Das Messsignal S2 wird optisch zu einer Empfangs- und Auswerteeinheit 70 übertragen, die sich auf Erdpotential befindet. Dazu ist eine optische Übertragungsstrecke 50 beispielsweise in Form einer Lichtwellenleiterverbindung vorgesehen. Die Messkopfelektronik 22 wird in der im Zusammenhang mit Figur 1 beschriebenen Weise über das Speisesignal S1 mit Energie E versorgt. Die optische Übertragung bewirkt in der Übertragungsstrecke 50 ähnlich wie die Übertragungs-Kapazitäten C2 und C3 in der Übertragungstrecke 40 eine Potentialtrennung, so dass die Anordnung 200 auch insgesamt potentialgetrennt ausgebildet ist. Sie eignet sich somit gut für einen Einsatz in der Hochspannungstechnik.

Bei einer anderen, nicht in Figur 2 dargestellten Ausführungsform ist eine ebenfalls vorgesehene optische Übertragungsstrecke nicht wie beim Beispiel von Figur 2 zur Übertragung eines Messsignals von Hochspannungs- auf Erdpotential, sondern zur Übertragung eines optischen Energiesignals in umgekehrter Richtung, also von Erd- auf Hochspannungspotential, bestimmt. Das optische Energieversorgungssystem ist zusätzlich zur Übertragungsstrecke 40 vorgesehen. Es dient insbesondere der Redundanz oder auch zur unterstützenden - ebenfalls potentialgetrennten - Energieeinspeisung im Falle eines besonders hohen Energiebedarfs im Verbraucher 20, beispielsweise während des Einschaltvorgangs. Zu Zeiten niedrigeren Energiebedarfs kann das zusätzliche optische Energieversorgungssystem in einen Stand-by-Modus geschaltet werden, wodurch für die Komponenten des optischen Energieversorgungssystems eine deutlich längere Lebensdauer resultiert. Der zusätzliche optische Energieversorgungspfad kann mit allen in den Figuren 1 bis 4 gezeigten Anordnungen 100 bis 400 kombiniert werden.

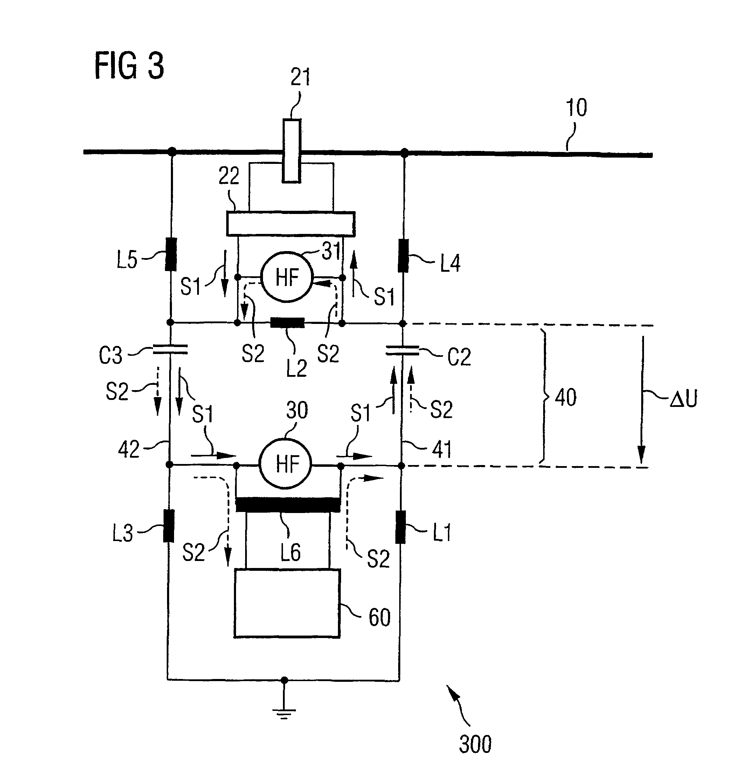

Bei einer in Figur 3 gezeigten weiteren Anordnung 300 ist der Verbraucher 20 als Strommessgerät ausgeführt, dem über das Speisesignal S1 potentialgetrennt Energie E zugeführt wird. Im Unterschied zur Anordnung 200 erfolgt die Übertragung des in der Messkopfelektronik 22 erzeugten Messsignals S2 nicht optisch, sondern elektrisch über die auch für das Speisesignal S1 genutzte und damit ohnehin vorhandene Übertragungsstrecke 40.

Das die Strominformation beinhaltende Messsignal S2 wird in einem zweiten Generator 31, der sich auf Hochspannungspotential befindet und Bestandteil des Strommessgeräts ist, als hochfrequentes Signal erzeugt, in die Übertragungstrecke 40 eingespeist und zu einer Empfangs- und Auswerteeinheit 60 übertragen. Das Messsignal S2 hat eine Messsignalfrequenz aus dem gleichen Frequenzbereich, aus dem auch die Speisefrequenz gewählt werden kann, also zwischen 1 kHz und 1 MHz. Um eine wechselseitige Beeinflussung zu vermeiden, haben die Mess- und die Speisefrequenz jedoch einen unterschiedlichen Frequenzwert. Im Beispiel von Figur 3 liegt die Speisefrequenz bei 10 kHz und die Messsignalfrequenz bei 100 kHz.

Eine zusätzliche, zum ersten Generator 30 und zur Empfangs- und Auswerteeinheit 60 parallel geschaltete Sperr-Induktivität L6 hat eine der Sperr-Induktivität L2 vergleichbare Wirkung. Sie sorgt dafür, dass das Messsignal S1 tatsächlich in die Empfangs- und Auswerteeinheit 60 gelangt, um dort ausgewertet werden zu können. Zur Verdeutlichung ist in Figur 3 auch der Signalpfad des Messsignals S2 durch Pfeile mit gestrichelter Linie angezeigt.

Die Anordnungen 200 und 300 können ähnlich wie die Anordnung 100 mit einer kapazitiven Spannungsmessung kombiniert werden, so dass sich insgesamt jeweils eine Anordnung zur kombinierten Strom- und Spannungsmessung ergibt. Außerdem können auch die Übertragungsstrecken 40 und 50 in einem in den Figuren 2 und 3 jeweils nicht dargestellten Isolator 80 angeordnet werden.

Die Anordnungen 100, 200 und 300 eignen sich für einen Einsatz bei einer DC- oder AC-Netzfrequenz des Hochspannungsleiters 10.

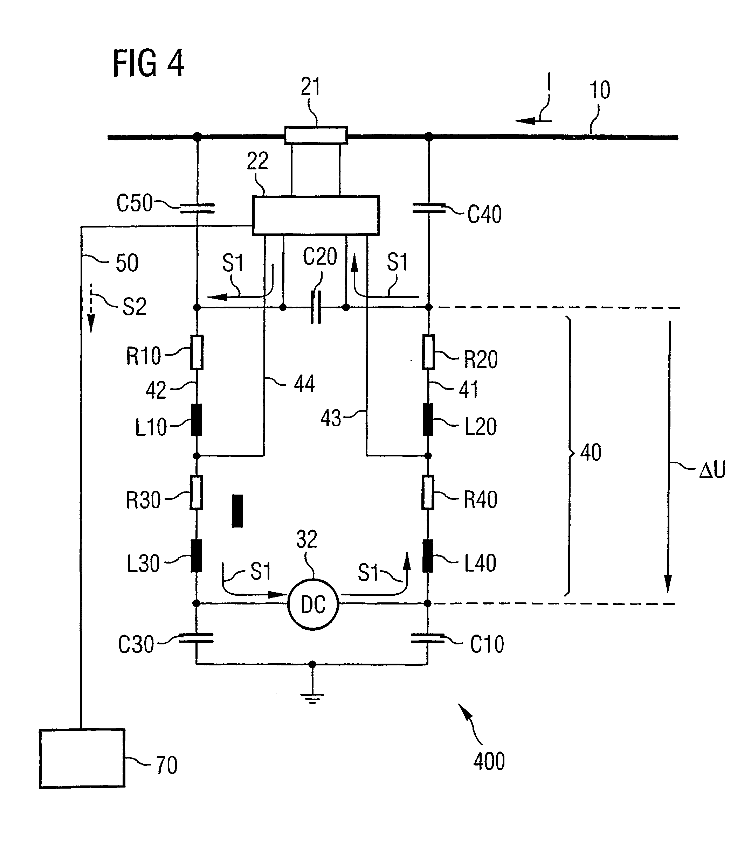

Bei einer in Figur 4 dargestellten weiteren für eine AC-Netzfrequenz bestimmten Anordnung zur potentialgetrennten Energieversorgung sind die bei den Anordnungen 100, 200 und 300 zur Aufnahme der Potentialdifferenz ΔU vorgesehenen Übertragungs-Kapazitäten C2 und C3 im wesentlichen durch Übertragungs-Induktivitäten L20 und L40 bzw. L10 und L30 ersetzt. Das Speisesignal S1 ist in diesem Beispiel ein Gleichsignal und wird mittels eines praktisch auf Erdpotential angeordneten DC-Generators 32 erzeugt. Die Übertragungs-Induktivitäten L10 bis L40 stellen für das DC-Speisesignal S1 einen Kurzschluss dar. Sie sind darüber hinaus so bemessen, dass sie bei der Netzfrequenz (= 50 Hz oder 60Hz) für die Aufnahme des Hochspannungspotentials geeignete Impedanzwerte annehmen.

Analog zu den Anordnungen 100, 200, und 300 hat auch die Anordnung 400 Mittel zur Vermeidung eines unerwünschten Abfließens von Speiseenergie. Diese sind aufgrund des hier vorliegenden DC-Speisesignals S1 jedoch nicht induktiv, sondern kapazitiv in Gestalt von Sperr-Kapazitäten C10 bis C50 ausgeführt. Sie stellen für das DC-Speisesignal S1 jeweils einen Leerlauf und bei der Netzfrequenz eine niederohmige Impedanz dar, so dass sie eine vergleichbare Wirkung wie die Sperr-Induktivitäten L1 bis L5 bei den Anordnungen 100, 200 und 300 entfalten. Durch den Einsatz eines Gleichsignals als Speisesignal S1 wird von vornherein eine unerwünschte Abstrahlung von Speiseenergie vermieden.

Für die Aufnahme der Potentialdifferenz ΔU und auch für die Übertragung des DC-Speisesignals S1 wäre es grundsätzlich ausreichend, jeweils nur eine der Übertragungs-Induktivitäten beispielsweise also L10 und L20 in den beiden Teilzweigen 42 bzw. 41 vorzusehen. Die beiden weiteren Übertragungs-Induktivitäten L30 und L40 sind ebenso wie in Reihe geschaltete Übertragungs-Widerstände R10 bis R40 zusätzlich vorgesehen, um mit der Anordnung 400 auch eine Spannungsmessung am Hochspannungsleiter 10 vornehmen zu können. In beiden Teilzweigen 41 und 42 wird dann jeweils ein ohmsch-induktiver Spannungsteiler gebildet, bei dem jeweils ein Mittenabzweig 43 bzw. 44 an die Messkopfelektronik 22 angeschlossen ist. Die Übertragungs-Widerstände R10 bis R40 dienen zum einen einer Bedämpfung einer gegebenenfalls auftretenden und unerwünschten Resonanz und zum anderen der Frequenzkompensation bei einer niedrigen Frequenz der zu erfassenden Messgröße auf dem Hochspannungsleiter 10. Sie können gegebenenfalls aber auch weggelassen werden.

In der Messkopfelektronik 22 wird also neben der mittels des Mess-Shunts 21 ermittelten Messinformation über den Strom I auch eine Messinformation über die Leiter-Erd-Spannung des Hochspannungsleiters 10 bestimmt. Das optisch übertragene Messsignal S2 enthält Informationen zu beiden erfassten Größen.

## Patentansprüche

1. Anordnung zum Versorgen eines benachbart zu einem Hochspannungsleiter (10) angeordneten elektrischen Messgeräts (20) auf Hochspannungspotential mit elektrischer Energie (E) umfassend mindestens:
- einen im Wesentlichen auf Massepotential liegenden Generator (30) zum Erzeugen eines Speisesignals (S1),
- eine Übertragungsstrecke (40) mit zwei den Generator (30) und das Messgerät (20) verbindenden Teilzweigen (41, 42),
wobei
- der erste Teilzweig (41) ausgelegt ist zur Übertragung des Speisesignals (S1) in Richtung vom Generator (30) zum Messgerät (20) und der zweite Teilzweig (42) ausgelegt ist zur Übertragung des Speisesignals (S1) in Richtung vom Messgerät (20) zum Generator (30),
- die Teilzweige (41, 42) über jeweils mindestens eine Induktivität (L4, L5) mit dem Hochspannungsleiter (10) verbunden sind,
- die Teilzweige (41, 42) zum Abbau der Potentialdifferenz zwischen Hochspannungspotential und im Wesentlichen Massepotential jeweils eine Kapazität (C2, C3) umfassen und
- die Kapazitäten (C2, C3) generatorseitig jeweils über mindestens eine Induktivität (L1, L3) im Wesentlichen auf Massepotential bezogen sind.

2. Anordnung nach Anspruch 1, bei der die beiden Teilzweige (41, 42) eng benachbart zueinander angeordnet sind.

3. Anordnung nach einem der vorhergehenden Ansprüche, bei der die beiden Teilzweige (41, 42) nebeneinander in einem Isolator (80) angeordnet sind.

4. Anordnung nach einem der vorhergehenden Ansprüche, bei der der jeweilige Kondensator (C2, C3) als Hochspannungskondensator eines kapazitiven Spannungswandlers ausgeführt ist und eine Niederspannungskapazität (C1) mit den beiden Teilzweigen (41, 42) zur Spannungsmessung, insbesondere zur Bestimmung der elektrischen Spannung zwischen dem Ort des Messgeräts (20) und Masse, verbunden ist.

5. Anordnung nach einem der vorhergehenden Ansprüche, bei der das Speisesignal (S1) eine Speisefrequenz von zwischen 1 kHz und 1 MHz hat.

6. Anordnung nach einem der vorhergehenden Ansprüche, bei der das Messgerät (20) mit einem ein Messsignal (S2) erzeugenden weiteren Generator (31) ausgestaltet ist, die Übertragungsstrecke (40) zur Übertragung des vom Messgerät (20) ermittelten Messsignals (S2) ausgelegt ist und eine zum im Wesentlichen auf Massepotential liegenden Generator (30) parallel geschaltete Empfangs- und Auswerteeinheit (70) zum Auswerten des Messsignals (S2) vorgesehen ist.

7. Anordnung nach einem der Ansprüche 1 bis 5, bei der eine zusätzliche, insbesondere optische, Übertragungsstrecke (50) zur Übertragung eines vom Messgerät (20) ermittelten Messsignals (S2) vorgesehen ist.

8. Anordnung zum Versorgen eines benachbart zu einem Hochspannungsleiter (10) angeordneten elektrischen Messgeräts (20) auf Hochspannungspotential mit elektrischer Energie (E) umfassend mindestens:
- einen im Wesentlichen auf Massepotential liegenden Generator (32) zum Erzeugen eines Speisesignals (S1),
- eine Übertragungsstrecke (40) mit zwei den Generator (32) und das Messgerät (20) verbindenden Teilzweigen (41, 42),
wobei
- das Hochspannungspotential ein Wechselspannungspotential ist,
- das Speisesignal (S1) als Gleichsignal ausgebildet ist,
- der erste Teilzweig (41) ausgelegt ist zur Übertragung des Speisesignals (S1) in Richtung vom Generator (32) zum Messgerät (20) und der zweite Teilzweig (42) ausgelegt ist zur Übertragung des Speisesignals (S1) in Richtung vom Messgerät (20) zum Generator (32),
- die Teilzweige (41, 42) über jeweils mindestens eine Kapazität (C40, C50) mit dem Hochspannungsleiter (10) verbunden sind,
- die Teilzweige (41, 42) zum Abbau der Potentialdifferenz zwischen Hochspannungspotential und im Wesentlichen Massepotential jeweils mindestens eine Induktivität (L10, L20, L30, L40) umfassen
und
- die mindestens eine Induktivität (L10, L20, L30, L40) jedes Teilzweigs (41, 42) generatorseitig jeweils über mindestens eine Kapazität (C10, C30) im Wesentlichen auf Massepotential bezogen ist.

9. Anordnung nach Anspruch 8, bei der die beiden Teilzweige (41, 42) eng benachbart zueinander angeordnet sind.

10. Anordnung nach Anspruch 8 oder 9, bei der eine zusätzliche, insbesondere optische, Übertragungsstrecke (50) zur
Übertragung eines vom Messgerät (20) ermittelten Messsignals (S2) vorgesehen ist.

11. Anordnung nach einem der vorhergehenden Ansprüche,
bei der das Messgerät (20) ein Strommessgerät ist.

12. Anordnung nach einem der Ansprüche 8 bis 10, bei der das Messgerät (20) zum Ermitteln eines elektrischen Stromes und einer elektrischen Spannung ausgelegt ist.

13. Anordnung nach Anspruch 12, bei der beide Teilzweige (41, 42) jeweils zwei Bauelementepaare beinhalten, wobei jedes Bauelementepaar eine Induktivität (L10, L20, L30, L40) und einen Widerstand (R10, R20, R30, R40) umfasst, und zur Spannungsmessung, insbesondere zur Bestimmung der elektrischen Spannung zwischen dem Ort des Messgeräts (20) und Masse, zwischen den beiden Bauelementepaaren (L10, R10, L30, R30, L20, R20, L40, R40) des jeweiligen Teilzweiges (41, 42) ein Mittenabzweig (43, 44) mit dem Messgerät (20) verbunden ist.

14. Anordnung nach einem der vorhergehenden Ansprüche, bei der eine zusätzliche optische Übertragungsstrecke zur bedarfsabhängigen zusätzlichen Energieversorgung des Messgeräts (20) vorgesehen ist.

## Claims

1. Arrangement for supplying an electrical test set (20), which is arranged adjacent to a high-voltage conductor (10) and is at high-voltage potential, with electrical power (E) comprising at least :
- a generator (30) which is essentially at earth potential, for producing a supply signal (S1),
- a transmission path (40) with two branch elements (41, 42) which connect the generator (30) and the test set (20), with
- the first branch element (41) being designed for transmission of the supply signal (S1) in the direction from the generator (30) to the test set (20) and the second branch element (42) being designed for transmission of the supply signal (S1) in the direction from the test set (20) to the generator (30),
- the branch elements (41, 42) being connected via in each case at least one inductor (L4, L5) to the high-voltage conductor (10),
- the branch elements (41, 42) each having a capacitance (C2, C3) in order to decrease the potential difference between the high-voltage potential and essentially earth potential, and
- the capacitances (C2, C3) each being connected essentially to earth potential on the generator side by at least one inductance (L1, L3).

2. Arrangement according to Claim 1, in which the two branch elements (41, 42) are arranged closely adjacent to one another.

3. Arrangement according to one of the preceding claims, in which the two branch elements (41, 42) are arranged alongside one another in an isolator (80).

4. Arrangement according to one of the preceding claims, in which each of the capacitors (C2, C3) is in the form of a high-voltage capacitor in a capacitive voltage transformer, and a low-voltage capacitance (C1) is connected to the two branch elements (41, 42) for a voltage measurement, in particular, in order to determine the electrical voltage between the location of the test set (20) and earth.

5. Arrangement according to one of the preceding claims, in which the supply signal (S1) is at a supply frequency of between 1 kHz and 1 MHz.

6. Arrangement according to one of the preceding claims, in which the test set (20) is designed with a further generator (31) which produces a measurement signal (S2), the transmission path (40) is designed for transmission of the measurement signal (S2) determined by the test set (20), and a receiving and evaluation unit (70) which is connected in parallel with the generator (30) that is essentially at earth potential, is provided for evaluation of the measurement signal (S2).

7. Arrangement according to one of Claims 1 to 5, in which an additional, and in particular optical, transmission path (50) is provided for transmission of a measurement signal (S2) determined by the test set (20).

8. Arrangement for supplying an electrical test set (20) which is arranged adjacent to a high-voltage conductor (10) and is at high-voltage potential, with electrical power (E), comprising at least :
- a generator (32) which is essentially at earth potential, for producing a supply signal (S1),
- a transmission path (40) with two branch elements (41, 42) which connect the generator (32) and the test set (20), with
- the high-voltage potential being an AC voltage potential,
- the supply signal (S1) being in the form of a DC signal,
- the first branch element (41) being designed for transmission of the supply signal (S1) in the direction from the generator (32) to the test set (20) and the second branch element (42) being designed for transmission of the supply signal (S1) in the direction from the test set (20) to the generator (32),
- the branch elements (41, 42) being connected to the high-voltage conductor (10) via in each case at least one capacitance (C40, C50),
- the branch elements (41, 42) each having at least one inductance (L10, L20, L30, L40) in order to decrease the potential difference between the high-voltage potential and essentially earth potential, and
- the at least one inductance (L10, L20, L30, L40) in each branch element (41, 42) in each case being connected essentially to earth potential on the generator side via at least one capacitance (C10, C30).

9. Arrangement according to Claim 8, in which the two branch elements (41, 42) are arranged closely adjacent to one another.

10. Arrangement according to Claim 8 or 9, in which an additional, in particular optical, transmission path (50) is provided for transmission of a measurement signal (S2) determined by the test set (20).

11. Arrangement according to one of the preceding claims, in which the test set (20) is an ammeter.

12. Arrangement according to one Claims 8 to 10, in which the test set (20) is designed to determine an electric current and an electrical voltage.

13. Arrangement according to Claim 12, in which both branch elements (41, 42) each include two component pairs, with each component pair having an inductance (L10, L20, L30, L40) and a resistance (R10, R20, R30, R40) and, for voltage measurement, in particular for determination of the electrical voltage between the location of the test set (20) and earth, a centre tap (43, 44) being connected to the test set (20) between the two component pairs (L10, R10, L30, R30, L20, R20, L40, R40) of the respective branch element (41, 42).

14. Arrangement according to one of the preceding claims, in which an additional optical transmission path is provided for the additional power supply for the test set (20) depending on the requirements.

## Revendications

1. Dispositif pour alimenter en énergie électrique (E) un appareil de mesure électrique (20) placé au voisinage d'un conducteur de haute tension (10) et se trouvant à un potentiel haute tension, comprenant au moins :
- un générateur (30), mis sensiblement au potentiel de masse, pour produire un signal d'alimentation (S1), et
- une voie de transmission (40) avec deux branches partielles (41, 42) reliant le générateur (30) et l'appareil de mesure (20),
et dans lequel
- la première branche partielle (41) est conçue pour transmettre le signal d'alimentation (S1) dans le sens allant du générateur (30) à l'appareil de mesure (20) et la deuxième branche partielle (42) est conçue pour transmettre le signal d'alimentation (S1) dans le sens allant de l'appareil de mesure (20) au générateur (30),
- les branches partielles (41, 42) sont reliées au conducteur de haute tension (10) chacune par l'intermédiaire d'au moins une inductance (L4, L5),
- les branches partielles (41, 42) comprennent chacune une capacité (C2, C3) pour réduire la différence de potentiel entre le potentiel haute tension et sensiblement le potentiel de masse
et
- les capacités (C2, C3) du côté du générateur sont mises sensiblement au potentiel de masse chacune par l'intermédiaire d'au moins une inductance (L1, L3).

2. Dispositif selon la revendication 1, dans lequel les deux branches partielles (41, 42) sont disposées très près l'une de l'autre.

3. Dispositif selon l'une des revendications précédentes, dans lequel les deux branches partielles (41, 42) sont disposées l'une à côté de l'autre dans un isolant (80).

4. Dispositif selon l'une des revendications précédentes, dans lequel le condensateur respectif (C2, C3) est réalisé comme condensateur à haute tension d'un convertisseur de tension capacitif et dans lequel une capacité à basse tension (C1) est reliée aux deux branches partielles (41, 42) pour la mesure de la tension, notamment pour la détermination de la tension électrique entre l'emplacement de l'appareil de mesure (20) et la masse.

5. Dispositif selon l'une des revendications précédentes, dans lequel le signal d'alimentation (S1) a une fréquence d'alimentation comprise entre 1 kHz et 1MHz.

6. Dispositif selon l'une des revendications précédentes, dans lequel l'appareil de mesure (20) est équipé d'un autre générateur (31) produisant un signal de mesure (S2), dans lequel la voie de transmission (40) est conçue pour la transmission du signal de mesure (S2) déterminé par l'appareil de mesure (20) et dans lequel une unité de réception et d'évaluation (70) branchée en parallèle avec le générateur (30) se trouvant sensiblement au potentiel de masse est prévue pour l'évaluation du signal de mesure (S2).

7. Dispositif selon l'une des revendications 1 à 5, dans lequel une voie de transmission supplémentaire (50), notamment optique, est prévue pour la transmission d'un signal de mesure (S2) déterminé par l'appareil de mesure (20).

8. Dispositif pour alimenter en énergie électrique (E) un appareil de mesure électrique (20) placé au voisinage d'un conducteur de haute tension (10) et se trouvant à un potentiel haute tension, comprenant au moins
- un générateur (32), mis sensiblement au potentiel de masse, pour produire un signal d'alimentation (S1), et
- une voie de transmission (40) avec deux branches partielles (41, 42) reliant le générateur (32) et l'appareil de mesure (20),
et dans lequel
- le potentiel haute tension est un potentiel de tension alternative,
- le signal d'alimentation (S1) est conçu comme un signal continu,
- la première branche partielle (41) est conçue pour transmettre le signal d'alimentation (S1) dans le sens allant du générateur (32) à l'appareil de mesure (20) et la deuxième branche partielle (42) est conçue pour transmettre le signal d'alimentation (S1) dans le sens allant de l'appareil de mesure (20) au générateur (32),
- les branches partielles (41, 42) sont reliées au conducteur de haute tension (10) chacune par l'intermédiaire d'au moins une capacité (C40, C50),
- les branches partielles (41, 42) comprennent chacune au moins une inductance (L10, L20, L30, L40) pour réduire la différence de potentiel entre le potentiel haute tension et sensiblement le potentiel de masse, et
- la ou les inductances (L10, L20, L30, L40) de chaque branche partielle (41, 42) du côté du générateur sont mises sensiblement au potentiel de masse à chaque fois par l'intermédiaire d'au moins une capacité (C10, C30).

9. Dispositif selon la revendication 8, dans lequel les deux branches partielles (41, 42) sont disposées très près l'une de l'autre.

10. Dispositif selon la revendication 8 ou 9, dans lequel une voie de transmission supplémentaire (50), notamment optique, est prévue pour la transmission d'un signal de mesure (S2) déterminé par l'appareil de mesure (20).

11. Dispositif selon l'une des revendications précédentes, dans lequel l'appareil de mesure (20) est un appareil de mesure de courant.

12. Dispositif selon l'une des revendications 8 à 10, dans lequel l'appareil de mesure (20) est conçu pour déterminer un courant électrique et une tension électrique.

13. Dispositif selon la revendication 12, dans lequel les deux branches partielles (41, 42) contiennent chacune deux couples de composants, chaque couple de composants comprenant une inductance (L10, L20, L30, L40) et une résistance (R10, R20, R30, R40), et dans lequel, pour la mesure de tension notamment pour la détermination de la tension électrique entre l'emplacement de l'appareil de mesure (20) et la masse, une dérivation médiane (43, 44) est reliée à l'appareil de mesure (20) entre les deux couples de composants (L10, R10, L20, R20, L30, R30, L40, R40) de la branche partielle respective (41, 42).

14. Dispositif selon l'une des revendications précédentes, dans lequel une voie de transmission supplémentaire optique est prévue pour l'alimentation en énergie supplémentaire, selon les besoins, de l'appareil de mesure (20).
